Europäisches Patentamt

European Patent Office

Office européen des brevets

(19)

(11) **EP 0 497 644 B1**

(12) **FASCICULE DE BREVET EUROPEEN**

(45) Date de publication et mention
de la délivrance du brevet:
**24.06.1998 Bulletin 1998/26**

(51) Int Cl.⁶: **H01L 21/3105**, H01L 21/027,
G03F 7/40, H01L 21/60

(21) Numéro de dépôt: **92400105.0**

(22) Date de dépôt: **15.01.1992**

(54) **Procédé de lithogravure sur substrat semi-conducteur, notamment pour le traitement localisé sur saillie**

Lithografisches Verfahren für Halbleitersubstrat, insbesondere für die lokalisierte Behandlung eines hervorstehenden Teiles

Lithographic process for semiconductor substrate, specifically for the treatment of a protrusion

(84) Etats contractants désignés:
**DE ES FR GB IT NL SE**

(30) Priorité: **17.01.1991 FR 9100505**

(43) Date de publication de la demande:
**05.08.1992 Bulletin 1992/32**

(73) Titulaire: **ALCATEL ALSTHOM COMPAGNIE GENERALE D'ELECTRICITE**
**75008 Paris (FR)**

(72) Inventeurs:
- **Poingt, Francis**
  **F-91700 Sainte Geneviève des Bois (FR)**
- **Lievin, Jean-Louis**
  **F-75012 Paris (FR)**
- **Gaumont-Goarin, Elisabeth**
  **F-92120 Montrouge (FR)**

(74) Mandataire: **Bourely, Paul et al**
**c/o ALCATEL ALSTHOM,**
**Département de Propriété Industrielle,**
**30, avenue Kléber**
**75116 Paris (FR)**

(56) Documents cités:
**EP-A- 0 300 563        WO-A-90/01796**
**FR-A- 2 599 892**

- **IBM TECHNICAL DISCLOSURE BULLETIN. vol. 32, no. 8B, Janvier 1990, NEW YORK US pages 443 - 445; ANONYME: 'Postsloped vias'**
- **MICROELECTRONIC ENGINEERING. vol. 9, no. 1-4, Mai 1989, AMSTERDAM NL pages 585 - 589; PANIEZ ET AL: 'Thermal flow properties of novolak polymers'**

## Description

La présente invention concerne la réalisation d'un traitement localisé tel que, notamment, la formation d'une fenêtre à travers une couche de revêtement au-dessus d'une zone formant saillie sur un substrat.

Elle s'applique plus particulièrement lorsque ladite couche de revêtement est une couche mince dont l'épaisseur est typiquement comprise entre 50 nm et 1000 nm, et lorsque ledit substrat présente une surface généralement plane sur laquelle ladite zone a une hauteur typiquement comprise entre 500 nm et 0,05 mm et une dimension transversale typiquement comprise entre 100 nm et 0,1 mm, environ.

Elle s'applique plus particulièrement encore lorsque le substrat est constitué d'un matériau semi-conducteur, lorsque la couche de revêtement est constitué d'un matériau diélectrique et lorsqu'une fenêtre doit être formée à travers cette couche pour permettre de prendre un contact électrique localisé sur le substrat. Tel est notamment le cas lors de la fabrication de certains lasers semi-conducteurs pour localiser un courant électrique assurant l'injection de porteurs de charges dans une couche active en forme de ruban qui est interne à ce laser.

Un procédé de lithogravure connu pour former une telle fenêtre comporte les opérations suivantes :

- dépôt d'une couche de revêtement sur un substrat présentant une zone en saillie sur laquelle une fenêtre doit être formée à travers cette couche de revêtement,
- dépôt sur ce substrat et cette couche de revêtement d'une couche d'une résine protectrice pour lithogravure,
- sensibilisation spatialement sélective de cette résine,
- ablation sélective de résine pour éliminer cette résine au-dessus de ladite zone en saillie,
- et gravure d'une fenêtre par application d'un procédé contre lequel cette résine constitue une protection.

Ce procédé connu est notamment décrit dans un livre "Modern GaAs processing Methods", de Ralph Williams, Editeur : Artech House Boston London, pages 115-133.

Il présente notamment l'inconvénient qu'il est difficile d'aligner avec la précision nécessaire le bord de la zone de sensibilisation sur le bord de la saillie sur laquelle une fenêtre doit être formée. Il en résulte que la fenêtre effectivement formée s'écarte de la position souhaitée.

Par ailleurs le document de brevet WO 90/01796 (Siemens) décrit un procédé dans lequel une couche de résine est déposée à l'extérieur d'une zone en saillie, puis on amène la résine à se déplacer par fluage vers cette zone en saillie pour accroitre son épaisseur à proximité immédiate de cette zone. La résine de ce document ne constitue pas une résine protectrice. En fait ce traitement vise seulement à égaliser ou à adoucir une surface qui présentait une saillie.

La présente invention a notamment pour but de permettre la formation d'une fenêtre dont les bords sont plus précisément alignés sur ceux d'une saillie sur laquelle cette fenêtre doit être formée. Et, dans ce but, elle a pour objet un procédé de traitement localisé sur saillie, notamment de lithogravure sur substrat semi-conducteur, procédé dans lequel on forme une couche de résine protectrice à l'extérieur d'une zone en saillie sur laquelle un traitement doit être effectué, puis on applique sur cette résine et sur cette zone un moyen de traitement contre lequel cette résine constitue une protection, ce procédé étant caractérisé par le fait que, ladite couche de résine protectrice est formée avec une épaisseur réduite à la périphérie de ladite zone en saillie, puisque avant d'appliquer ledit moyen de traitement, on amène ladite résine protectrice à se déplacer par fluage vers cette zone en saillie pour au moins accroître son épaisseur à proximité immédiate de cette zone.

Un tel déplacement par fluage permet de constituer ou de renforcer une couche de protection en bordure extérieure de la zone en saillie en utilisant pour cela des forces, telles que les forces de tension superficielle ou de gravité, qui sont capables, en l'absence de toute commande spatialement sélective, de limiter leur action au bord de la zone en saillie, grâce au profil des flancs de cette zone et éventuellement à un choix convenable des mouillabilités des diverses zones du substrat par la résine protectrice.

A l'aide des figures schématiques ci-jointes, on va décrire ci-après comment la présente invention peut être mise en oeuvre, étant entendu que les éléments et dispositions mentionnés et représentés ne le sont qu'à titre d'exemples non limitatifs. Lorsqu'un même élément matériel ou une grandeur de même nature est représenté sur plusieurs figures il ou elle y est désigné par un même signe de référence.

La figure 1 représente des vues selon un plan transversal d'un premier substrat à des étapes successives de la mise en oeuvre d'un procédé selon la présente invention.

La figure 2 représente des vues analogues d'un deuxième substrat à des étapes analogues d'un tel procédé.

La figure 3 représente des vues analogues d'un troisième substrat à des étapes analogues d'un tel procédé.

La figure 4 représente des vues de ce deuxième substrat, l'une après application du procédé de la présente invention et les autres après application de procédés de lithogravure qui sont analogues mais qui ne mettent pas cette invention en oeuvre.

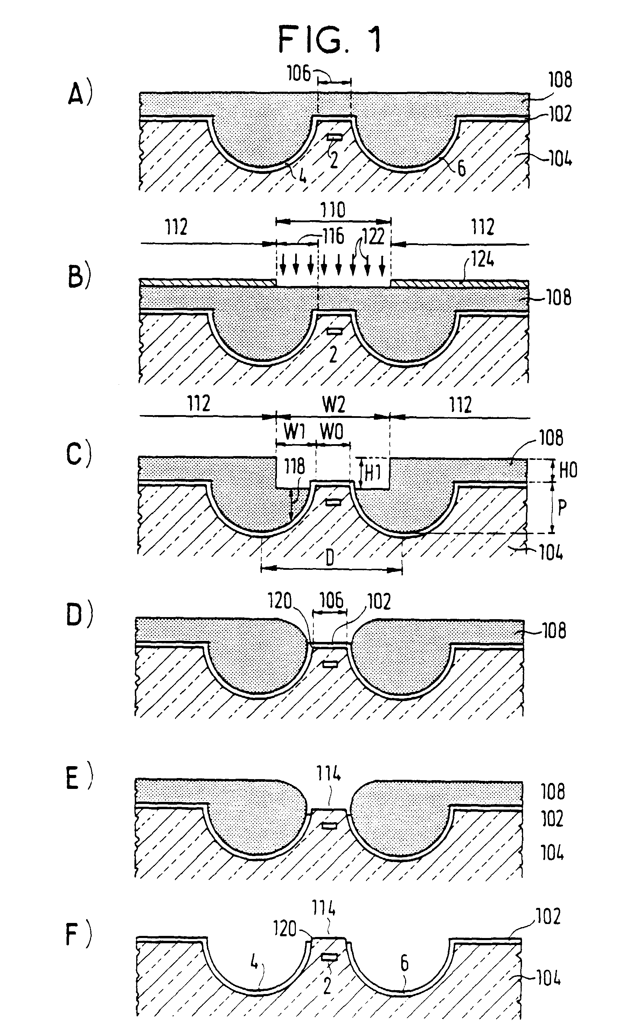

On va tout d'abord décrire de manière générale, en se référant à la figure 1, une succession d'opérations qui visent à la formation d'une fenêtre et qui sont communes, quant à leurs fonctions indiquées, au procédé selon l'invention et audit procédé connu.

- Dépôt de revêtement. Cette opération comporte le dépôt d'une couche de revêtement mince constituée d'un matériau de revêtement 102 sur un substrat 104 présentant une zone en saillie 106 sur laquelle une fenêtre doit être formée à travers cette couche de revêtement.
- Dépôt de résine. Cette opération comporte le dépôt sur ce substrat 104 et cette couche de revêtement 102 d'une couche 108, (figure 1A) constituée d'une résine protectrice sensibilisable et ayant une épaisseur suffisante pour recouvrir la zone en saillie 106.
- Sensibilisation spatialement sélective de cette résine pour la sensibiliser à un premier procédé d'ablation de résine dans une zone de sensibilisation 110, (figure 1B) s'étendant au-dessus de la zone en saillie 106, cette résine n'étant pas sensibilisée à ce procédé dans une zone 112 extérieure à cette zone de sensibilisation.
- Ablation sélective de résine par ledit premier procédé d'ablation de résine. Cette opération élimine cette résine au-dessus de la zone en saillie 106 et la laisse subsister, (figure 1C) dans la zone extérieure 112.
- Et gravure d'une fenêtre 114 par application d'un procédé d'ablation de revêtement contre lequel la couche de résine protectrice 108 constitue une protection.

Par rapport à ce procédé connu, la présente invention peut se différencier par les points suivants :

- La résine protectrice 108 (figures 1C et 1D) est choisie pour pouvoir fluer lorsqu'elle est placée dans des conditions de fluage quine lui font pas perdre ses qualités protectrices et qui sont supportables par le substrat 104 et la couche de revêtement 102. La zone de sensibilisation inclue alors non seulement la zone en saillie 106 mais aussi au moins une bande de sensibilisation supplémentaire 116 de largeur limitée qui s'étend au delà d'au moins un bord 120 de cette zone en saillie. De plus, ladite ablation sélective de résine est une ablation ménagée pour laisser la résine protectrice subsister avec une épaisseur réduite 118 (figure 1C) dans cette bande de sensibilisation supplémentaire, et une opération de fluage de résine est effectuée après cette ablation ménagée de résine et avant ladite gravure de fenêtre. Cette opération de fluage comporte l'application desdites conditions de fluage pour que les forces de tension superficielle de cette résine amène une fraction de la masse de celle-ci dans la bande de sensibilisation supplémentaire 116 jusqu'au bord 120 de la zone saillie, à partir de la zone extérieure 112. Par ailleurs, une condition anti-mouillage est respectée pour que, lors de cette opération de fluage, cette résine ne s'étende pas sur la couche de revêtement 102 dans la zone en saillie 106.

La présence d'une épaisseur de résine suffisante sur les bords de la saillie, sans débordement de résine sur cette saillie, a pour effet que les bords de la fenêtre qui sera gravée à travers la couche de revêtement s'aligneront avec une grande précision sur ceux de cette saillie alors que les bords de la zone de sensibilisation peuvent être définis avec un degré de précision bien plus petit. Elle a aussi pour effet de réaliser une protection de la couche de revêtement sur les flancs de la zone en saillie.

Pour la mise en oeuvre du procédé selon la présente invention, on peut adopter en outre les dispositions avantageuses suivantes :

- Les conditions de fluage incluent une température de fluage supérieure à celle à laquelle est réalisée ladite opération d'ablation ménagée de résine. Cette disposition présente l'avantage que la réalisation de l'opération de fluage à l'aide d'une élévation de température est souvent relativement simple. D'autre modes de réalisation de cette opération peuvent cependant être avantageux dans certains cas. On peut par exemple alors placer le substrat avec la couche de revêtement et la résine de protection dans une enceinte où règne une pression de vapeur importante ou saturante d'un solvant qui imprègne alors cette résine et la fluidifie.
- Dans le cas où on utilise une élévation de température pour réaliser le fluage, on choisit une résine de protection présentant une différence importante, par exemple de l'ordre de 50C, entre une température de transition vitreuse et une température d'altération qui est supérieure et au delà de laquelle des propriétés utiles de la résine seraient altérées, notamment en ce qui concerne la possibilité de l'éliminer ultérieurement complètement du substrat. La température de fluage est alors choisie entre ces deux températures. Cette disposition présente l'avantage de permettre d'atteindre facilement une température permettant le fluage de la résine sans risquer de lui faire perdre ses propriétés utiles.

Selon une autre disposition avantageuse, ladite condition anti-mouillage est que la résine protectrice est non mouillante pour ledit matériau de revêtement. Bien entendu cette même résine doit présenter une certaine adhérence sur ce même matériau de revêtement lors de ladite opération de dépôt de résine. Cette adhérence peut notamment résulter du fait que, lors de ce dépôt, cette résine comporte une proportion importante d'un solvant qui est volatil et qui est éliminé ensuite lors d'opérations de recuits. Cette disposition présente l'avantage que, pour la mettre en oeuvre, il suffit de choisir une résine convenable. Encore faut-il pour cela qu'une telle résine soit disponible. Si elle ne l'est pas, une disposition alternative serait par exemple que, après l'ablation ménagée de résine, on dépose sur la couche de revêtement, dans le plateau de la zone en saillie mais non sur les flancs de saillie, un produit en couche très mince qui s'opposerait au mouillage par la résine.

Compte tenu de l'erreur de positionnement que l'on peut faire lors du positionnement du bord de la zone de sensibilisation par rapport au bord de la zone en saillie, la largeur effective de la bande de sensibilisation supplémentaire peut s'écarter d'une largeur théorique W1 qui serait obtenue en l'absence d'erreur. Si on considère l'erreur maximale qui peut affecter ce positionnement, cette largeur effective peut se situer de manière aléatoire entre une limite inférieure égale à la largeur théorique diminuée de l'erreur maximale et une limite supérieure égale à la largeur théorique augmentée de l'erreur maximale. On choisit donc une largeur théorique supérieure à l'erreur maximale. Il convient cependant de ne pas choisir une largeur théorique excessivement grande qui nécessiterait que la résine se déplace par fluage sur une grande distance, et obligerait donc inutilement à créer des conditions de fluage relativement difficiles à obtenir.

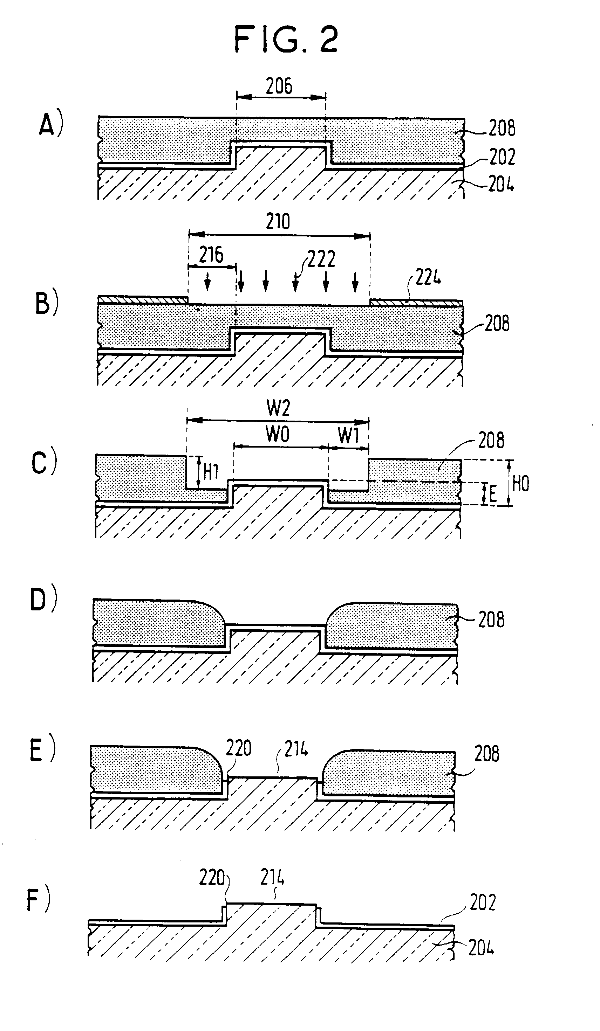

Dans de nombreux cas de fabrication de lasers semiconducteurs la largeur W2 de la zone de sensibilisation est avantageusement choisie dans l'intervalle $2W0 < W2 < 3W0$, W0 étant la largeur de la zone en saillie, ce qui entraîne $W0/2 < W1 < W0$ (voir figure 2C).

Selon une autre disposition avantageuse, ladite sensibilisation spatialement sélective est une insolation effectuée par un rayonnement 122 (figure 1B) à travers un masque amovible 124. Cette disposition présente l'avantage d'utiliser un procédé de photolithogravure qui est bien connu et quine présente pas de difficulté particulière dans le cadre de la présente invention.

Dans beaucoup d'applications de cette invention, après le perçage d'une fenêtre 114, on effectue une ablation complète de la résine par un deuxième procédé d'ablation de résine.

Dans ces applications ledit substrat est typiquement un substrat semi-conducteur et ladite couche de revêtement est une couche diélectrique. De plus, après le perçage de fenêtre, on effectue un dépôt de matériau conducteur pour permettre le passage d'un courant électrique à travers la fenêtre formée. Ce dépôt de matériau conducteur n'est pas représenté.

On va maintenant décrire d'une manière un peu plus particulière des mises en oeuvres du procédé qui vient d'être décrit. Ces mises en oeuvres utilisent les dispositions avantageuses qui ont été indiquées ci-dessus.

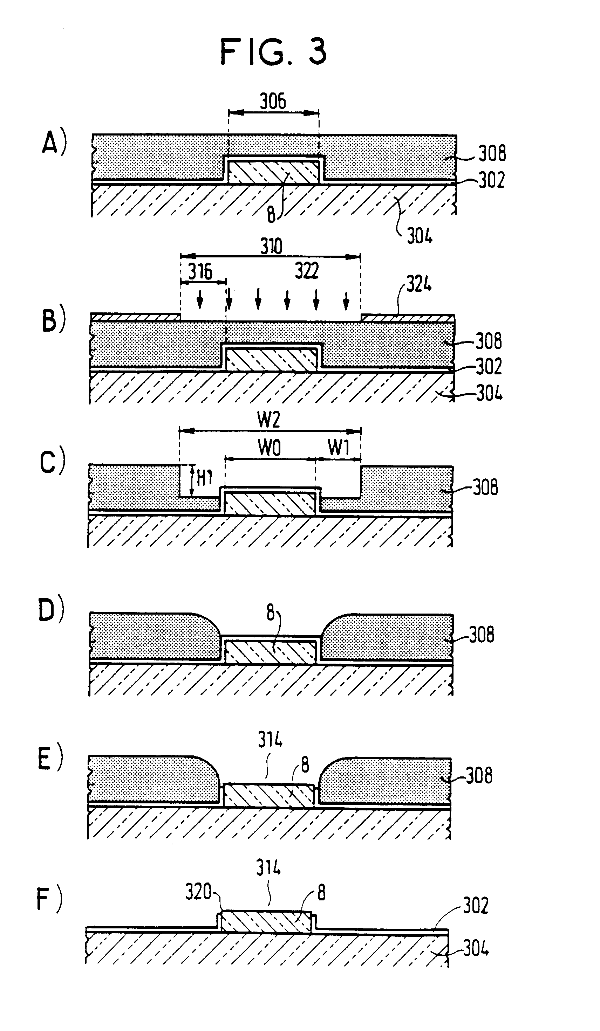

Les figures 2 et 3 représentent des éléments homologues de ceux qui ont été mentionnés avec référence à la figure 1. Lorsque trois éléments sont homologues sur ces trois figures leurs trois numéros de référence comportent les mêmes chiffres des dizaines et des unités, les chiffres des centaines étant égaux aux numéros des figures correspondantes.

Les lettres A à F désignent sur ces trois figures des étapes analogues du procédé de l'invention.

Conformément à la figure 1, le substrat 104 est destiné à la fabrication d'un laser semi-conducteur dit à ruban enterré dont la couche active 2 en forme de ruban s'étend perpendiculairement au plan de la figure. Cette couche est encadrée par deux canaux d'isolement 4 et 6 qui ont été gravés dans ce substrat sur une largeur limitée avec une distance entre axes D et une profondeur P. Ces canaux laissent subsister entre eux la zone en saillie 106 dont la largeur est voisine de 0,005 mm. De tels lasers sont connus sous les sigles FBH ou PBH, SIBC, DCPBH.

Il apparaît convenable dans ce cas de respecter les inégalités suivantes :

$$W2 \leq D \text{ et } H0 \geq P/2$$

H0 étant l'épaisseur de résine déposée, lors de ladite opération de dépôt de résine, sur la partie non gravée du substrat. L'épaisseur de résine H1 enlevée lors de l'opération d'ablation ménagée de résine est alors supérieure à H0 mais inférieure à $H0 + P/2$.

Conformément à la figure 2, la formation d'une saillie résulte d'une gravure du substrat 204 sur toute la surface de celui-ci sauf sur la zone en saillie 206 dont la largeur W0 est de l'ordre de 0,002 mm. Le procédé selon la présente invention permet la localisation de l'injection de courant dans une crète de laser appelée internationalement "laser ridge" et constituée par la zone en saillie 206 qui s'étend perpendiculairement au plan de la feuille (voir figure 2C).

Dans ce cas, si on appelle H0 l'épaisseur de résine déposée à distance de la zone en saillie 206 et E la hauteur du plateau de cette zone par rapport à la surface environnante, il y a intérêt à ce que H0 soit au moins égal à 2E.

Conformément à la figure 3, la formation d'une zone en saillie 306 résulte d'un dépôt d'un matériau d'apport 8 sur un substrat 304. Ce matériau d'apport a été déposé sous forme de couche puis gravé pour former un ruban qui s'étend perpendiculairement au plan de la figure et qui a une largeur de l'ordre de 0,001 mm.

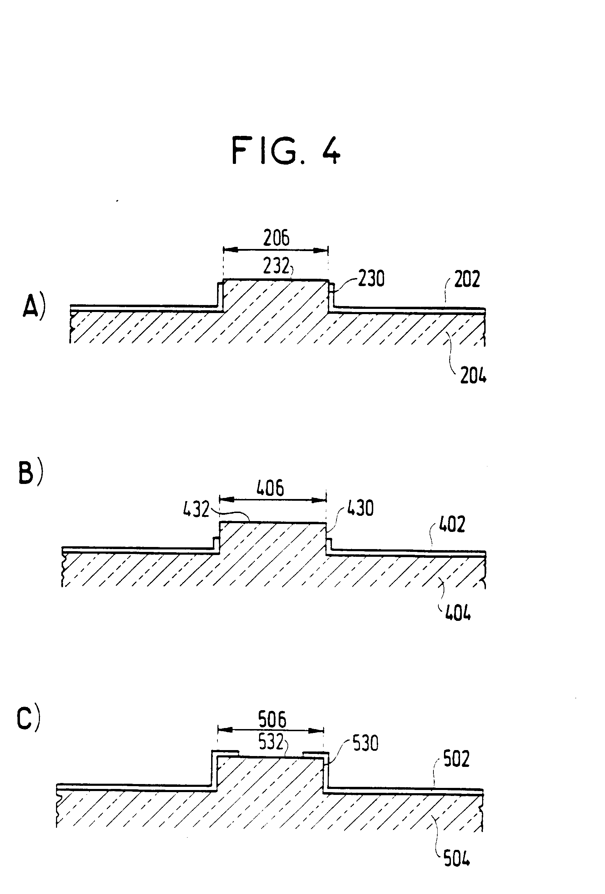

La figure 4A correspond à la figure 2F, c'est-à-dire qu'elle représente le résultat obtenu par le procédé de l'invention. Il apparaît que la couche de revêtement 202 subsiste, sur le flanc tel que 230 de la zone en saillie 206, jusqu'au voisinage du plateau 232 de cette zone.

Les procédés utilisés pour traiter les substrats 404 et 504 des figures 4B et 4C sont analogues au procédé selon l'invention précédemment décrite mais ne comportent pas d'opération de fluage de résine.

Conformément à la figure 4B, lorsque la zone de sensibilisation a été plus large que la zone en saillie 406 et lorsque l'ablation ménagée de résine a laissé subsister une couche protectrice efficace autour de cette zone, la couche de revêtement 402 est éliminée sur le flanc 430 de la zone en saillie 406 jusqu'à une distance relativement grande du plateau 432 de cette zone.

Conformément à la figure 4C, lorsque la zone de sensibilisation a été un peu plus étroite que la zone en saillie 506, la couche de revêtement 502 subsiste sur les bords du plateau 532 de cette zone.

Dans une mise en oeuvre du procédé de la présente invention dans le cas de la figure 1, la couche de revêtement 102 était constituée de nitrure de silicium et avait une épaisseur H0 de 200 nm et la zone en saillie 106 avait une hauteur P, par rapport aux zones environantes du substrat 104, de l'ordre de 2000 nm.

On a choisi, pour constituer la résine de protection 208, une résine photosensible du genre novolaque vendue sous la référence TF20 et la marque de commerce Microposit par la firme américaine Shipley. Lors de l'opération de dépôt de résine, cette résine a été étalée sur tournette à 5000 tr/mn pendant 30 secondes puis à 10 000 tr/mn pendant 3 secondes. Un recuit à 90°C pendant 20 minutes a ensuite été réalisé. L'épaisseur obtenue était de 0,005 mm au-dessus de la zone en saillie. L'opération d'insolation a duré 25 secondes avec une puissance de 20 mW/cm2. L'opération d'ablation ménagée a été faite en deux fois quinze secondes à l'aide d'un révélateur vendu par la même firme sous la référence 351 et dilué dans six volumes d'eau. Elle a été contrôlée au microscope optique. L'opération de fluage de résine a résulté d'un recuit à une température de fluage de 150°C pendant 15 minutes. Le perçage de fenêtre à travers le revêtement diélectrique (Si$_3$N$_4$) a été fait à l'aide d'un plasma de CF4 (100 W, 15 minutes). L'ablation complète de résine a été faite à l'aide d'un solvant vendu par la firme américaine General Chemical sous la référence A20 Stripper.

Un avantage important du procédé selon la présente invention est qu'il dispense d'un alignement précis du masque d'insolation par rapport aux zones en saillies que l'on souhaite dégager. Ce procédé procure en effet un alignement "automatique" (auto-alignement) des bords de la couche de résine de protection sur ceux de la zone saillie lors de l'opération de fluage. Cet auto-alignement améliore la qualité d'un composant tel qu'un laser semi-conducteur dont la fabrication comporte la mise en oeuvre de ce procédé.

Un second avantage est qu'une définition précise du bord de la fenêtre ne nécessite pas l'appui d'un masque d'insolation dur sur la surface du substrat. Il résulte du fait que la définition du bord de la zone de sensibilisation peut être relativement imprécise. Il est important lorsqu'on travaille sur des substrats fragiles tels que ceux qui sont constitués d'arseniure de gallium GaAs ou de phosphore d'indium InP.

## Revendications

1. Procédé de traitement localisé sur saillie, notamment de lithogravure sur substrat semiconducteur, procédé dans lequel on forme une couche de résine protectrice à l'extérieur d'une zone en saillie sur laquelle un traitement doit être effectué, puis on applique sur cette résine et sur cette zone un moyen de traitement contre lequel cette résine constitue une protection, ce procédé étant caractérisé par le fait que ladite couche de résine protectrice (108) est formée avec une épaisseur réduite (118) à la périphérie de ladite zone en saillie (106), puis que, avant d'appliquer ledit moyen de traitement, on amène cette résine à se déplacer par fluage vers cette zone pour au moins accroître son épaisseur à proximité immédiate de cette zone.

2. Procédé selon la revendication 1, procédé dans lequel on effectue les opérations suivantes pour effectuer un dit traitement localisé consistant à former une fenêtre sur ladite zone en saillie :

   - dépôt de revêtement, cette opération comportant le dépôt d'une couche de revêtement mince constituée d'un matériau de revêtement (102) sur un substrat (104) présentant ladite zone en saillie (106),
   - dépôt de résine, cette opération comportant le dépôt sur ce substrat (104) et cette couche de revêtement (102) de la couche (108) de résine protectrice sensibilisable cette couche ayant une épaisseur suffisante pour recouvrir ladite zone en saillie,
   - sensibilisation spatialement sélective de cette résine pour la sensibiliser à un premier procédé d'ablation de résine dans une zone de sensibilisation (110) s'étendant au-dessus de ladite zone en saillie (106), cette résine n'étant pas sensibilisée à ce procédé dans une zone (112) extérieure à cette zone de sensibilisation,
   - ablation sélective de résine par ledit premier procédé d'ablation de résine pour éliminer cette résine au-dessus de ladite zone en saillie (106) en la laissant subsister dans ladite zone extérieure (112),
   - et gravure d'une fenêtre (114) dans ladite couche de revêtement par application d'un moyen d'ablation de revêtement constituant un dit moyen de traitement qui est apte à éliminer ledit matériau de revêtement et contre lequel ladite couche de résine protectrice constitue une protection,
   - ce procédé étant caractérisé par le fait que ladite résine protectrice (108) est choisie pour pouvoir fluer lorsqu'elle est placée dans des conditions de fluage quine lui font pas perdre ses qualités protectrices et qui sont supportables par ledit substrat (104) et ladite couche de revêtement (102),

- ladite zone de sensibilisation (110) incluant non seulement ladite zone en saillie (106) mais aussi au moins une bande de sensibilisation supplémentaire (116) présentant une largeur limitée au delà d'au moins un bord de cette zone en saillie,

- ladite ablation sélective de résine étant une ablation ménagée pour laisser ladite résine protectrice subsister avec une épaisseur réduite (118) dans ladite bande de sensibilisation supplémentaire (116),

- une opération de fluage de résine étant effectuée après cette ablation ménagée de résine et avant ladite gravure de fenêtre par application desdites conditions de fluage pour que les forces de tension superficielles de cette résine et/ou de gravité amènent une fraction de la masse de celle-ci dans ladite bande de sensibilisation supplémentaire jusqu'au bord (120) de ladite zone en saillie à partir de ladite zone extérieure (112).

3. Procédé selon la revendication 2, caractérisé par le fait que lesdites conditions de fluage incluent une température de fluage supérieure à la température à laquelle a été réalisée ladite ablation ménagée de résine.

4. Procédé selon la revendication 3, caractérisé par le faut que ladite résine de protection (108) présente une différence importante entre une température de transition vitreuse et une température d'altération, ladite température de fluage étant comprise entre ces deux températures.

5. Procédé selon la revendication 2 dans lequel ladite résine protectrice (108) est non mouillante pour ledit matériau de revêtement (102).

6. Procédé selon la revendication 2, dans lequel ladite sensibilisation spatialement sélective est une insolation effectuée par un rayonnement (122) à travers un masque amovible (124).

7. Procédé selon la revendication 2 dans lequel, après le dit perçage d'une fenêtre (114), on effectue une ablation complète de ladite résine par un deuxième procédé d'ablation de résine.

8. Procédé selon la revendication 2, dans lequel ledit substrat (104) est un substrat semi-conducteur et ladite couche de revêtement (102) est une couche diélectrique.

9. Procédé selon la revendication 8 dans lequel, après ledit perçage de fenêtre, on effectue un dépôt de matériau conducteur pour permettre le passage d'un courant électrique à travers ladite fenêtre.

**Patentansprüche**

1. Verfahren zur lokalisierten Behandlung für einen hervorstehenden Teil, insbesondere der Lithographie für ein Halbleitersubstrat, bei welchem Verfahren eine schützende Harzschicht außerhalb eines hervorstehenden Bereichs gebildet wird, auf dem eine Behandlung vorgenommen werden soll, dann auf dieses Harz und auf diesen Bereich ein Behandlungsmittel aufgebracht wird, gegen welches dieses Harz einen Schutz bildet, wobei dieses Verfahren dadurch gekennzeichnet ist, daß die schützende Harzschicht (108) mit am Rand des hervorstehenden Bereichs (106) verringerter Dicke (118) ausgebildet wird, dann daß vor dem Aufbringen des Behandlungsmittels dieses Harz dazu gebracht wird, sich durch Fließen zu diesem Bereich hin zu bewegen, um wenigstens seine Dicke in direkter Nähe dieses Bereichs zu vergrößern.

2. Verfahren nach Anspruch 1, bei welchem Verfahren die folgenden Arbeitsgänge ausgeführt werden, um eine lokalisierte Behandlung vorzunehmen, die im Ausbilden eines Fensters in dem hervorstehenden Bereich besteht:

- Niederlegen eines Überzugs, wobei dieser Arbeitsgang das Niederlegen einer dünnen Überzugsschicht umfaßt, die aus einem Überzugsmaterial (102) auf einem Substrat (104) besteht, das den hervorstehenden Bereich (106) aufweist,

- Niederlegen eines Harzes, wobei dieser Arbeitsgang das Niederlegen der Schicht (108) aus sensibilisierbarem, schützendem Harz auf diesem Substrat (104) und dieser Überzugsschicht (102) umfaßt; wobei diese Schicht eine ausreichende Dicke hat, um den hervorstehenden Bereich zu bedecken,

- selektive räumliche Sensibilisierung dieses Harzes, um es für einen ersten Vorgang zur Entfernung des Harzes in einem Sensibilisierungsbereich (110) zu sensibilisieren, der sich über dem hervorstehenden Bereich (106) erstreckt, wobei dieses Harz in einem Bereich (112) außerhalb dieses Sensibilisierungsbereichs nicht für diesen Vorgang sensibilisiert wird,

- selektive Entfernung des Harzes durch den ersten Vorgang zur Entfernung des Harzes, um dieses Harz über dem hervorstehenden Bereich (106) zu entfernen, wobei es im äußeren Bereich (112) stehen gelassen wird,

- und Gravur bzw. Ätzen eines Fensters (114) in die Überzugsschicht durch Anwendung eines Mittels zur Entfernung des Überzugs, das ein Behandlungsmittel bildet, das zur Entfernung des Überzugsmaterials geeignet ist und gegen welches die schützende Harzschicht einen Schutz bildet,

- wobei dieses Verfahren dadurch gekennzeichnet ist, daß das schützende Harz (108) so ausgewählt wird, daß es fließen kann, wenn es unter Fließbedingungen gesetzt wird, die es seine schützenden Eigenschaften nicht verlieren lassen und denen das Substrat (104) und die Überzugsschicht (102) standhalten können,
- wobei der Sensibilisierungsbereich (110) nicht nur den hervorstehenden Bereich (106) sondern auch wenigstens einen zusätzlichen Sensibilisierungsstreifen (116) beinhaltet, der eine begrenzte Breite jenseits wenigstens eines Randes dieses hervorstehenden Bereichs aufweist,
- wobei die selektive Entfernung des Harzes eine Entfernung ist, die dafür vorgesehen ist, das schützende Harz mit einer verringerten Dicke (118) im zusätzlichen Sensibilisierungsstreifen (116) stehen zu lassen,
- wobei ein Arbeitsgang des Fließens des Harzes nach dieser vorgesehen Entfernung des Harzes und vor der Gravur bzw. dem Ätzen des Fensters durch Anwendung der Fließbedingungen ausgeführt wird, damit die Kräfte der Grenzflächenspannung dieses Harzes und/oder die Schwerkraft einen Anteil der Masse dieses vom äußeren Bereich (112) aus in den zusätzlichen Sensibilisierungsstreifen bis zum Rand (120) des hervorstehenden Bereichs bringen.

3. Verfahren nach Anspruch 2, dadurch gekennzeichnet, daß die Fließbedingungen eine Fließtemperatur beinhalten, die höher als die Temperatur ist, bei der die vorgesehene Entfernung des Harzes ausgeführt wurde.

4. Verfahren nach Anspruch 3, dadurch gekennzeichnet, daß das Schutzharz (108) einen großen Unterschied zwischen einer Glasübergangstemperatur und einer Änderungstemperatur aufweist, wobei die Fließtemperatur zwischen diesen beiden Temperaturen liegt.

5. Verfahren nach Anspruch 2, bei dem das schützende Harz (108) für das Überzugsmaterial (102) nicht benetzend ist.

6. Verfahren nach Anspruch 2, bei dem die selektive räumliche Sensibilisierung eine Sonnenbestrahlung ist, die durch eine Strahlung (122) durch eine abnehmbare Maske (124) hindurch vorgenommen wird.

7. Verfahren nach Anspruch 2, bei dem nach dem Durchbruch eines Fensters (114) eine vollständige Entfernung des Harzes durch einen zweiten Vorgang für die Entfernung des Harzes vorgenommen wird.

8. Verfahren nach Anspruch 2, bei dem das Substrat (104) ein Halbleitersubstrat und die Überzugsschicht (102) eine dielektrische Schicht ist.

9. Verfahren nach Anspruch 8, bei dem nach dem Durchbruch des Fensters ein Niederlegen von leitendem Material vorgenommen wird, um den Durchgang eines elektrischen Stromes durch das Fenster hindurch zu gestatten.

## Claims

1. A method of localized treatment on a projection, in particular lithographic etching on a semiconductor substrate, in which method a protective resin layer is formed outside a projecting zone on which treatment is to be performed, the treatment means against which said resin provides protection is then applied on said resin and on said zone, said method being characterized by the fact that said protective resin layer (108) is formed with a reduced thickness (118) at the periphery of said projecting zone (106), then, prior to applying said treatment means, said resin is caused to move by plastic flow towards said zone to at least increase its thickness in the immediate vicinity of said zone.

2. A method according to claim 1, in which method the following operations are performed to effect said localized treatment which consists in forming a window on said projecting zone:

coating deposition, this operation including depositing a layer of thin coating constituted by a coating material (102) on a substrate (104) having said projecting zone (106);
resin deposition, this operation comprising depositing on said substrate (104) and said coating layer (102) the layer (108) of sensitizable protective resin, said layer having sufficient thickness to cover said projecting zone;
sensitizing selected areas of said resin to sensitize it to a first resin ablation process in a sensitized zone (110) extending over said projecting zone (106), said resin not being sensitized to said process in a zone (112) outside said sensitized zone;
selectively ablating the resin by said first resin ablation process to eliminate said resin over said projecting zone (106) and allowing it to remain in said outside zone (112); and

etching a window (114) in said coating layer by applying a coating ablation means constituting one of said treatment means which is suitable for eliminating said coating material and against which said layer of protective resin constitutes a protection;

said method being characterized by the fact that said protective resin (108) is selected so as to be capable of plastic flow when placed in plastic flow conditions that do not cause it to loose its protective qualities and which can be withstood by said substrate (104) and by said coating layer (102);

said sensitized zone (110) including not only said projecting zone (106) but also at least one additional sensitized strip (116) of limited width beyond at least one of the edges of said projecting zone;

said selective ablation of the resin being restrained ablation to allow said protective resin to remain at reduced thickness (118) in said additional sensitized strip (116); and

an operation of causing plastic flow of the resin being performed after said restrained ablation of the resin and before said etching of the window by applying said plastic flow conditions so that the forces of gravity and/or of surface tension of said resin bring a fraction of the mass thereof from said outside zone (112) into said additional sensitized strip up to the edge (120) of said projecting zone.

3. A method according to claim 2, characterized by the fact that said plastic flow conditions include a plastic flow temperature greater than the temperature at which said restrained ablation of the resin is performed.

4. A method according to claim 3, characterized by the fact that said protective resin (108) has a large difference between a vitreous transition temperature and a spoiling temperature, with said plastic flow temperature lying between said two temperatures.

5. A method according to claim 2, in which protective resin (108) is not wettable for said coating material (102).

6. A method according to claim 2, in which said sensitization in selected areas is insulation performed by radiation (122) through a removable mask (124).

7. A method according to claim 2, in which, after said forming of a window (114), said resin is completely ablated by a second resin ablation process.

8. A method according to claim 2, in which said substrate (104) is a semiconductor substrate and said coating layer (102) is a dielectric layer.

9. A method according to claim 8, in which, after said window has been formed, conductive material is deposited to enable electricity to flow through said window.

# FIG. 1

# FIG. 2

# FIG. 3

# FIG. 4

A)

206
232
230
202
204

B)

432
406
430
402
404

C)

506
532
530
502
504